# EUROPÄISCHE PATENTSCHRIFT

(11) **EP 1 198 607 B1**
(45) Veröffentlichungstag und Bekanntmachung des Hinweises auf die Patenterteilung: **29.12.2004**
(21) Anmeldenummer: 00929190.7
(22) Anmeldetag: 22.05.2000
(51) Int. Cl.: C23C 14/00, C23C 14/54, H01J 37/34

(54) **VAKUUMBEHANDLUNGSANLAGE UND VERFAHREN ZUR HERSTELLUNG VON WERKSTÜCKEN**
VACUUM TREATMENT INSTALLATION AND METHOD FOR PRODUCING WORKPIECES
INSTALLATION DE TRAITEMENT SOUS VIDE ET PROCEDE DE PRODUCTION DE PIECES

(30) Priorität: 25.05.1999 CH 96499
(43) Veröffentlichungstag der Anmeldung: 24.04.2002
(73) Patentinhaber: Unaxis Balzers Aktiengesellschaft, 9496 Balzers (LI)
(72) Erfinder: ZUEGER, Othmar, FL-9495 Triesen (LI)
(74) Vertreter: Troesch Scheidegger Werner AG
(86) Internationale Anmeldenummer: PCT/CH2000/000286
(87) Internationale Veröffentlichungsnummer: WO 2000/071774

(56) Entgegenhaltungen:
- GB-A- 813 251
- US-A- 5 225 057
- US-A- 5 423 970
- PATENT ABSTRACTS OF JAPAN vol. 018, no. 271 (C-1203), 24. Mai 1994 (1994-05-24) & JP 06 041732 A (MITSUBISHI KASEI CORP), 15. Februar 1994 (1994-02-15)
- PATENT ABSTRACTS OF JAPAN vol. 016, no. 071 (C-0913), 21. Februar 1992 (1992-02-21) & JP 03 264667 A (SHIN MEIWA IND CO LTD), 25. November 1991 (1991-11-25)
- PATENT ABSTRACTS OF JAPAN vol. 1999, no. 05, 31. Mai 1999 (1999-05-31) & JP 11 050239 A (KOBE STEEL LTD), 23. Februar 1999 (1999-02-23)

## Beschreibung

Die vorliegende Erfindung betrifft eine Vakuumbehandlungsanlage mit einer Vakuumbehandlungskammer, mit Organen zum Erstellen einer Behandlungsatmosphäre in der Kammer, einer Sensoranordnung zur Erfassung der in einem Behandlungsbereich in der Kammer momentan vorherrschenden Behandlungsatmosphäre, wobei die Sensoranordnung IST-Wertaufnehmer, mindestens eines der Organe Stellglied eines Regelkreises für die Behandlungsatmosphäre ist, weiter mit einem durch den Behandlungsbereich getrieben bewegten Werkstückträger.

Im weiteren betrifft die vorliegende Erfindung Verfahren zum Herstellen von Werkstücken, bei welchen die Werkstücke in einer durch eine Regelung geführten Behandlungsatmosphäre bewegt werden.

Bei der Vakuumbehandlung von Werkstücken ist es bekannt, die Behandlungsatmosphäre durch eine oder mehrere Regelungen auf den Einhalt vorgegebener Eigenschaften zu regeln. Dies ist insbesondere dann notwendig, wenn die zur Realisation einer erwünschten Behandlungsatmosphäre in einer Vakuumbehandlungskammer ablaufenden Prozesse in erwünschten Arbeitspunkten an sich instabil sind und erst mittels einer Regelung stabilisiert werden können. Ein hierfür typisches Beispiel sind reaktive Sputterprozesse zur Beschichtung von Substraten mit nicht-leitenden, so typischerweise oxidischen Schichten, bei denen ein metallisches, DC-betriebenes Target, typischerweise eine Magnetronanordnung, in einer Reaktivgasatmosphäre eingesetzt wird. Nebst einem inerten Arbeitsgas, beispielsweise Argon, wird der Behandlungsatmosphäre das Reaktivgas, beispielsweise Sauerstoff Sauerstoff oder Stickstoff, zugeführt. Einerseits führt dies zu einer - gewollten - Beschichtung der Werkstücke mit einer oft elektrisch schlecht leitendenden Schicht, beispielsweise einer Oxidbeschichtung, aber auch zu einer Störbeschichtung des metallischen Targets. Ein solcher reaktiver Sputterprozess ist ohne Arbeitspunkt-Regelung im sogenannten Ubergangsmode bzw. Intramode nicht stabil zu betreiben. Bezüglich der detaillierten Beschreibung von reaktiven Sputterprozessen im genannten Ubergangsmode wird auf die US-A-5 423 970 derselben Anmelderin verwiesen.
In derartigen Regelungen wird die Regelgrösse (IST-Wertmessung) durch Messung der Plasmalichtemission, beispielsweise bei einer spezifischen Spekrallinie, durch Messung der Targetspannung erfasst. Es wird für die gemessene Regelgrösse ein SOLL-Wert vorgegeben und entsprechend den Regelabweichungen beispielsweise der Fluss von Reaktivgas, im oben gegebenen Beispiel der Sauerstofffluss, oder - falls nicht als Regelgrösse erfasst - die Targetspannung als Stellgrösse im erwähnten Regelkreis gestellt. Hierdurch wird der Betrieb, insbesondere eine Stabilisierung des Prozesses im erwünschten Arbeitspunkt, beispielsweise im erwähnten Übergangsmode, erreicht.

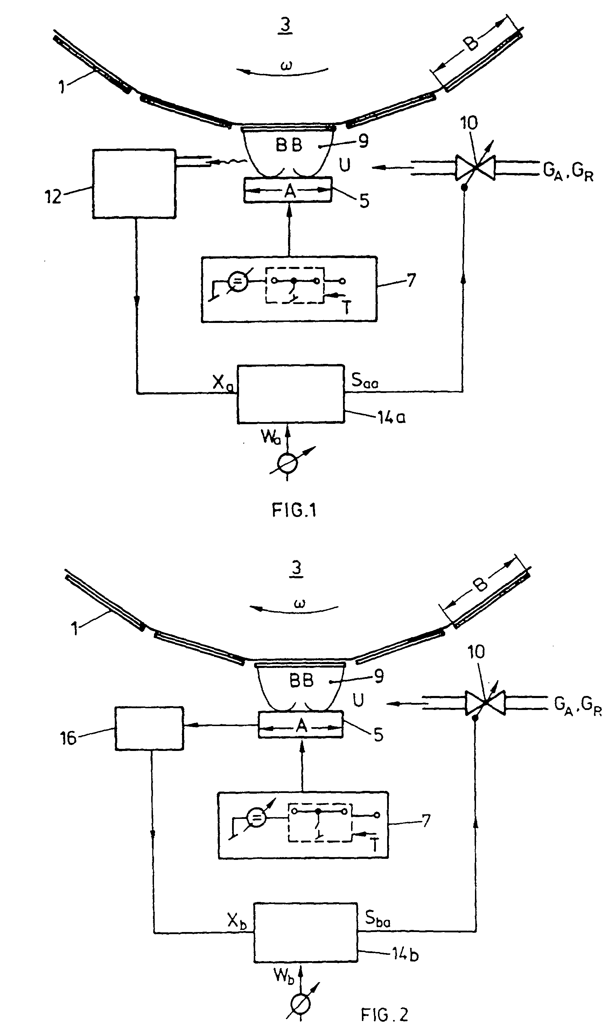

In den Figuren 1 bis 4 sind schematisch typische Vakuumbehandlungsanlagen letztgenannter Art dargestellt. Es sind solche Anlagen bzw. mit Anlagen dieser Art realisierte Werkstück-Herstellverfahren, an denen die noch zu beschreibenden Probleme erkannt und erfindungsgemäss gelöst wurden. Die erfindungsgemässen Lösungen können aber grundsätzlich an Anlagen und Verfahren eingangs genannter Art eingesetzt werden, woran der Behandlungsprozess bzw. die Behandlungsatmosphäre geregelt wird.

Substrate 1 werden auf einer - wie mit ω dargestellt - in einer Behandlungskammer drehenden Werkstückträgertrommel 3 an mindestens einer Sputterquelle 5 vorbeibewegt. Die Sputterquelle 5 mit metallischem, also elektrisch hoch leitendem Target, wird, üblicherweise als Magnetronquelle ausgebildet, DCbetrieben, oft zusätzlich mit zwischen einem DC-Speisegenerator und der Sputterquelle 5 zwischengeschalteter Choppereinheit, wie dies ausführlich in der EP-A-0 564 789 derselben Anmelderin beschrieben ist. Mit einer solchen Choppereinheit wird ein über den Sputterquellen-Anschlüssen liegender Strompfad intermittierend hoch- und niederohmig geschaltet.

In den Fig. 1 bis 4 sind der DC-Generator und die gegebenenfalls vorgesehene Choppereinheit jeweils in den Blöcken 7 der Sputterquellenspeisung dargestellt. In die Behandlungsatmosphäre U der Vakuumkammer wird, nebst einem Arbeitsgas G_{A}, beispielsweise Argon, ein Reaktivgas G_{R}, beispielsweise Sauerstoff O₂, eingelassen, insbesondere letzteres über Gasfluss-Stellventile 10.

Es bildet sich über den Sputterquellen 5 ein reaktives Plasma 9, in welchem die mit der Trommel 3 über den Sputterflächen durchbewegten Substrate bzw. Werkstücke 1 sputterbeschichtet werden. Weil nicht nur die Substrate 1 mit den im reaktiven Plasma 9 gebildeten, elektrisch schlecht leitenden Reaktionsprodukten beschichtet werden, sondern auch die metallischen Sputterflächen der Sputterquellen 5, ist der bis dahin beschriebene Beschichtungsprozess, insbesondere zum Erzielen möglichst hoher Beschichtungsraten, instabil. Deshalb wird insbesondere bei diesen Behandlungsverfahren bzw. -anlagen der Behandlungsprozess, dabei eigentlich die auf die Werkstücke 1 wirkende Behandlungsatmosphäre, im Behandlungsbereich BB durch eine Regelung stabilisiert.

Gemäss Fig. 1, als eine mögliche Realisationsvariante eines solchen Regelkreises, werden mittels eines Plasmaemissionsmonitors 12 die Intensitäten einer oder mehrerer der für die Lichtemission aus dem reaktiven Plasma 9 kennzeichnenden Spektrallinie(n) gemessenen und als gemessene Regelgrösse Xₐ einem Regler 14ₐ zugeführt.

Gemäss Fig. 2 wird, als gemessene IST-Grösse X_{b} des Regelkreises, mit einer Spannungsmesseinrichtung 16 die Targetspannung an der Sputterquelle 5 gemessen und einem Regler 14b zugeführt.

Bezüglich Erfassung der gemessenen Regelgrösse X entsprechen sich die Figuren 1 und 3 bzw. 2 und 4. An den Reglern 14a bzw. 14b werden die jeweils gemessenen Regelgrössen Xₐ bzw. X_{b}, zur Bildung jeweiliger Regeldifferenzen, mit den gemessenen Regelgrössen entsprechenden, vorzugsweise einstellbaren Führungswerten Wₐ bzw. W_{b} verglichen.

Nach Massgabe der gebildeten Regeldifferenzen an den Reglern 14a bzw. 14b und deren Verstärkung an bezüglich Frequenzverhalten gemäss den Regeln der Regelungstechnik bemessenen Übertragungsstrecken (nicht separat dargestellt) werden, ausgangsseits der Regler 14, Stellsignale S generiert. Gemäss den Fig. 1 und 2 werden die Stellsignale, entsprechend mit Sₐₐ und S_{ba} bezeichnet, auf die Flusssteuerventile 10 für das Reaktivgas als Stellglieder geführt, welche so gestellt werden, dass die jeweilig gemessenen Regelgrössen Xₐ bzw. X_{b} auf die mittels der Führungsgrössen Wₐ bzw. W_{b} vorgegebenen Werte geführt bzw. dort gehalten werden.

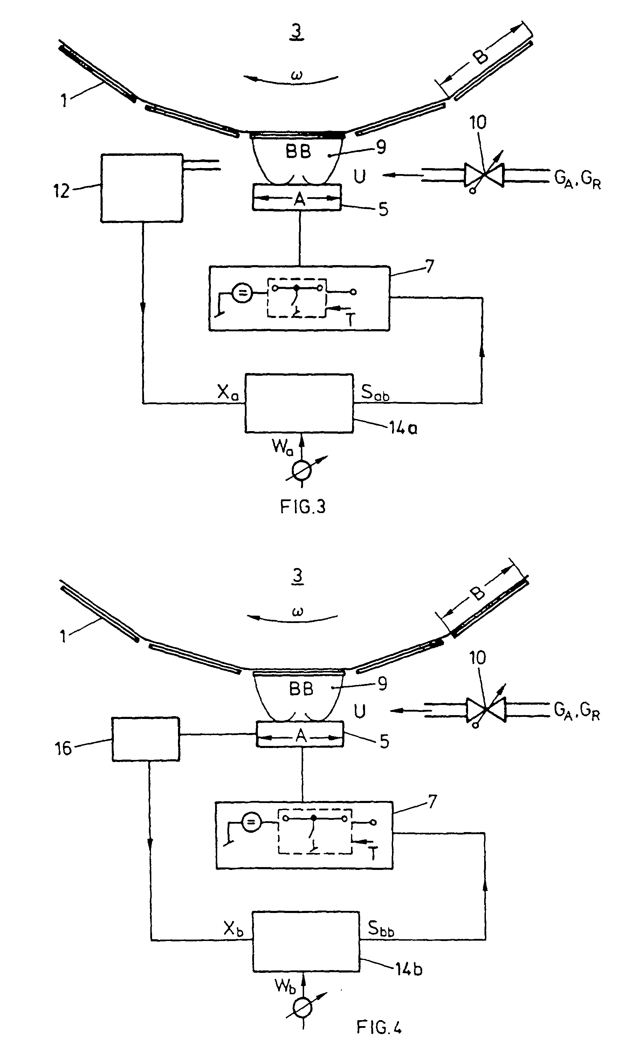

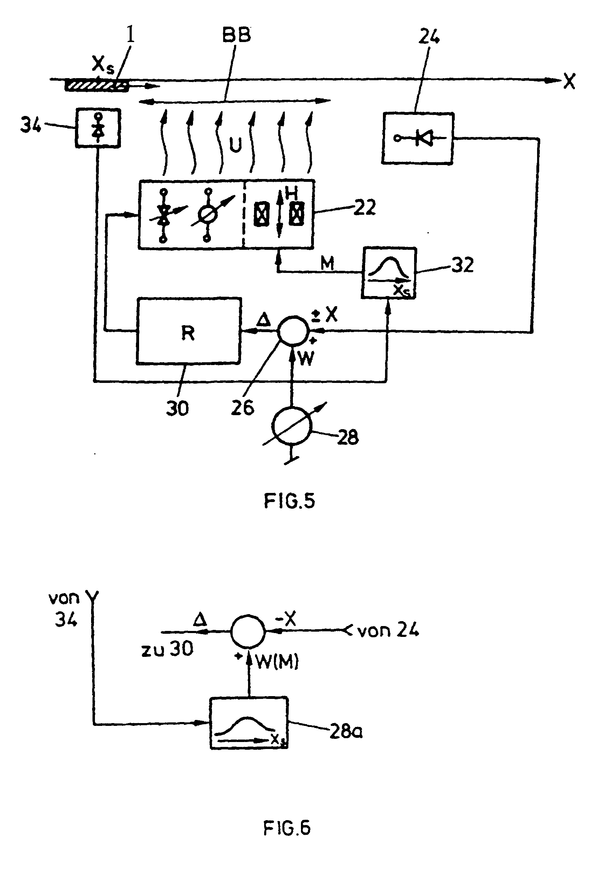

Gemäss den Fig. 3 und 4 wird das ausgangsseitig der Regler 14a bzw. 14b generierte Stellsignal, entsprechend mit S_{ab} und S_{bb} bezeichnet, an die nun ihrerseits als Regelungsstellglieder wirkende Sputterquellen-Speisungen 7 geführt, sei dies an deren DC-Generatoren und/oder an deren gegebenenfalls vorgesehenen Choppereinheiten, wo der Chopper-duty-cycle gestellt wird.

Es handelt sich also bei den anhand von Fig. 1 bis 4 beispielsweise dargestellten Anlagen um Vakuumbehandlungsanlagen mit einer Vakuumbehandlungskammer, mit Organen zum Erstellen einer Behandlungsatmosphäre - nämlich insbesondere Sputterquelle und Reaktivgaszuführungen, einer Sensoranordnung zur Erfassung der in der Kammer momentan vorherrschenden Behandlungsatmosphäre - den beispielsweise beschriebenen Plasmaemissionsmonitoren bzw. Spannungsmessgeräten, wobei die Sensoranordnungen IST-Wertaufnehmer, mindestens eines der erwähnten Organe Stellglied jeweils eines Regelkreises für die Behandlungsatmosphäre bilden.

Für das Ablegen elektrisch schlecht oder nicht leitender Schichten mit Hilfe Freisetzens der einen Schichtmaterial-Komponente von elektrisch leitenden Targets besteht ein aus der US-A-5 225 057 bekanntes Vorgehen darin, in räumlich getrennten Behandlungsstufen erst die metallische Beschichtung vorzunehmen und diese darnach in einer Reaktivgasstufe, einer Oxidationsstufe, zu oxidieren. Bei diesem bekannten Vorgehen besteht ein Stabilitätsproblem bezüglich des Beschichtungsprozesses nicht, hingegen wird die hierzu eingesetzte Anlagekonfiguration - mehrstufig - relativ kompliziert.

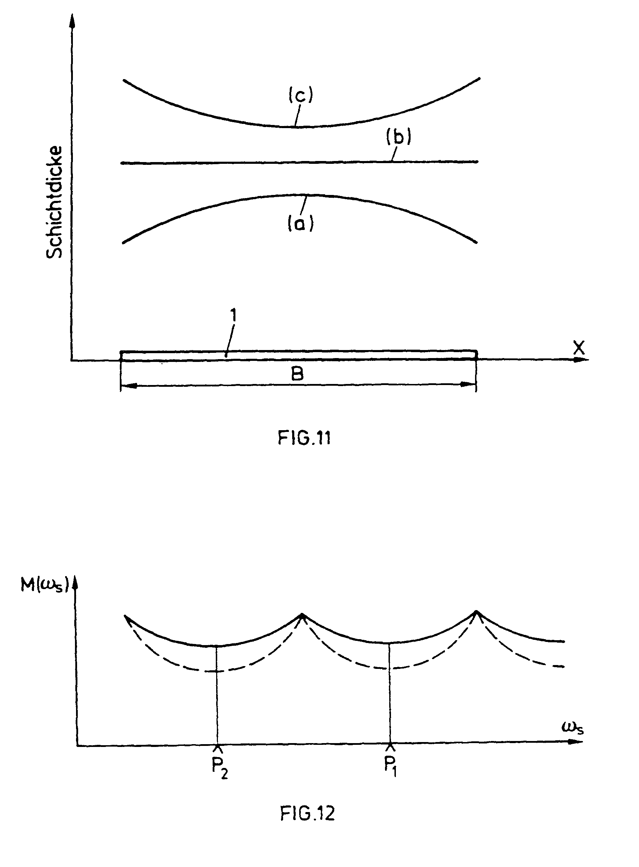

Wie erwähnt, geht die vorliegende Erfindung von Behandlungsanlagen bzw. Herstellungsverfahren der anhand der Figuren 1 bis 4 erläuterten Art aus. Daran wurde erkannt, dass insbesondere bei breiten Substraten, mit einer Breite B grösser als die Ausdehnung A in gleicher Richtung, vorzugsweise fünfmal grösser, und/oder bei kleinem Durchmesser der Substrattrommel 3 sich über der Substratbreite B, aufgrund der nicht geradlinigen Bewegung der Substrate im Bereich BB und relativ zur Sputterquelle 5 eine ausgeprägte, angenähert parabolische Schichtdickenverteilung ergibt, wie dies in Fig. 11a dargestellt ist. Diese Schichtdicken-Verteilung ist als sogenannter "Sehneneffekt" bekannt.

Als wirksame Breite eines Substrates wird dessen linear gemessene Ausdehnung verstanden, in Richtung seiner Relativbewegung zur Sputterquelle 5; die entsprechende wirksame Sputterquellenausdehnung A ist deren linear gemessene Ausdehnung in derselben Richtung betrachtet.

Im weiteren kann die erwähnte "Substratbreite B" durchaus von mehreren nebeneinander liegenden, kleineren Substraten eingenommen werden, das angesprochene Substrat 1 ist dann eigentlich ein Batch-Substrat.

Im weiteren sei an dieser Stelle betont, dass beispielsweise mit Blick auf Fig. 1 die Substrate durchaus auf der Innenseite eines umlaufenden Karussells angeordnet werden können, welches eine Sputterquellenanordnung umläuft, auf einer bezüglich der Sputterquellenanordnung dann konkaven Bahn. Alle bisherigen und nachfolgenden Ausführungen, ausgehend von den Trommelanordnungen gemäss den Fig. 1 bis 4, gelten, analog, vollumfänglich für konkave Werkstückbewegungen bezüglich der Sputterquelle.

Die vorliegende Erfindung stellt sich zur Aufgabe, unabhängig von der Bewegungsbahn und -ausrichtung der in der Behandlungsatmosphäre bewegten Werkstücke, gezielt eine erwünschte Schichtdicken-Verteilung zu realisieren.

Dies wird an einer Vakuumbehandlungsanlage eingangs genannter Art durch die Gegenstände der Ansprüche 1 und 5 erreicht.

Dabei ist nun zu berücksichtigen, dass bei der Anlage bzw. dem Verfahren eingangs genannter Art die Regelung, z.B. für die Stabilisierung des Behandlungsprozesses, die Behandlungsatmosphäre in einem SOLL-Zustand bzw. Arbeitspunkt hält.

Anders als aus der US 5 225 057 bekannt, wonach durch Variation der Sputterleistung beim Ablegen metallischer Schichten dem Sehneneffekt gegengewirkt wird, liegt vorliegenderfalls eine Regelung vor, welche sich einer Veränderung der Behandlungsatmosphäre widersetzt.

In einer ersten Ausführungsform der erfindungsgemässen Vakuumbehandlungsanlage ist am Regelkreis eine einstellbare SOLL-Wert-Vorgabeeinheit vorgesehen, wie dies anhand der Fig. 1 bis 4 erläutert wurde, und es wird die erfindungsgemäss vorgesehene Modulation synchron mit der Substratbewegung über Modulation des SOLL-Wertes realisiert.

In einer weiteren Ausführungsform der erfindungsgemässen Anlage wird die vorgesehene Regelung langsamer ausgeführt als die erfindungsgemäss vorgenommene Behandlungsatmosphären-Modulation. Demnach kann die Regelung der "Störgrössen"-Modulation gar nicht ausregelend folgen. Es handelt sich mithin bei der erfindungsgemäss eingeführten Modulation, regelungstechnisch, um das bewusste Einführen einer Störgrösse, die nicht ausgeregelt werden soll.

Umfasst, wie in der bevorzugten, bereits anhand der Fig. 1 bis 4 erläuterten Anlage, die Vakuumkammer eine Sputterquelle mit elektrisch leitendem Target und ist an die Kammer eine Reaktivgas-Tankanordnung angeschlossen mit einem Reaktivgas, welches mit dem durch die Sputterquelle freigesetzten Material zu einem elektrisch schlechter leitenden Material als Beschichtungsmaterial reagiert, so wird bevorzugterweise die Modulation an der elektrischen Quelle für die Speisung der Sputterquelle vorgenommen - dessen Strom oder Leistung -, sei dies bei bevorzugter DC-Speisung am DC-Generator selber und/oder an einem zwischen DC-Generator und Sputterquelle geschalteten Chopper, dessen duty-cycle erstellt wird.

In einer weiteren bevorzugten Ausführungsform weist die erfindungsgemässe Anlage, als bewegter Werkstückträger, eine rotierend getriebene Trägertrommel auf mit an seiner Peripherie verteilten Werkstückaufnahmen. Die Modulation wird dann mit der Trommel-Drehbewegung synchronisiert und mit einer Repetitionsfrequenz angelegt, die der Werkstückträger-Durchlauffrequenz entspricht.

Im weiteren wird bevorzugterweise an der erfindungsgemässen Anlage eine Modulationsformen-Speichereinheit vorgesehen, mit mindestens einem, vorzugsweise mehr vorabgespeicherten Modulationsverläufen sowie mit einer Selektionseinheit zur selektiven Aufschaltung der jeweils erwünschten Modulationskurven auf das erwähnte Stellorgan.

Das erfindungsgemässe Verfahren eingangs genannter Art zur Herstellung von Werkstücken zeichnet sich dadurch aus, dass die Behandlungsatmosphäre in einem Behandlungsbereich der Werkstück-Bewegungsbahn, in Funktion der Werkstück-Position, mit einem gegebenen Profil moduliert wird. Bevorzugte Ausführungsformen des erfindungsgemässen Verfahrens sind in den Ansprüchen 7 bis 13 spezifiziert. Die erfindungsgemässe Anlage wie auch das erfindungsgemässe Verfahren eignen sich insbesondere zum Erstellen einer homogenen Schichtdickenverteilung an planen Substraten mit Durchmessern B grösser als die wirksame Ausdehnung A der Sputterquelle oder zur Erzeugung von vorgegebenen Schichtdicken-Verteilungen an Substraten, so insbesondere auch an nicht planen Substraten.

Die vorliegende Erfindung betrifft im weiteren grundsätzlich Verfahren zur Herstellung von Substraten, wobei der Sehneneffekt an den Substraten, die auf einer bezüglich einer Sputterquelle konvexen oder konkaven Kreisbahn an der Sputterquelle vorbeibewegt werden, kompensiert wird.

Aus der US-A-5 225 057 ist es bekannt, die Sputterleistung metallischer Targets zur Kompensation des vorerwähnten Sehneneffektes zu modulieren, und zwar so, dass bei zentrisch gegenüber der Sputterquelle liegenden Substraten die Sputterleistung ein Maximum durchläuft. Genauere Untersuchungen haben aber gezeigt, dass diese Modulationsart den angesprochenen Sehneneffekt nicht zu kompensieren vermag. Erstaunlicherweise muss nämlich, wie gezeigt werden wird, die Sputterleistung der Quelle in Funktion der Substratposition so moduliert werden, dass bei zentral gegenüber der Sputterquelle liegenden Substraten die Sputterleistung ein Minimum durchläuft.

Im weiteren werden erfindungsgemässe Herstellverfahren vorgeschlagen, bei denen insbesondere Auswirkungen des erwähnten Sehneneffektes, bei bezüglich Sputterquelle konvexer oder konkaver Substratbewegung, durch Modulation des Reaktivgasflusses - bei den bevorzugt eingesetzten Reaktivbeschichtungsprozessen - und/oder der Arbeitsgasfluss, d.h. der Fluss eines Inertgases, behoben werden.

Bei Modulation der Sputterleistung und konkaver Bewegungsbahn der Substrate bezüglich der Sputterquelle wird bevorzugt die Sputterleistung bei zentrisch gegenüber der Sputterquelle liegenden Werkstücken auf ein Maximum moduliert.

Entsprechend wird bei konvexer Bewegungsbahn der Substrate bezüglich der Sputterquelle der Reaktivgasfluss so moduliert, dass bei zentrisch gegenüber der Sputterquelle liegenden Werkstücken dieser Fluss ein Maximum durchläuft, ist die Substratbewegungsbahn hingegen konkav, ein Minimum.

Wird allein oder in Kombination mit den übrigen angegebenen Modulationsgrössen der Arbeitsgasfluss erfindungsgemäss moduliert, so bevorzugt in einer Art und Weise, dass er bei konvexer Bewegungsbahn der Substrate bezüglich der Sputterquelle bei zentrisch gegenüber der Sputterquelle liegenden Werkstücken ein Minimum durchläuft, hingegen bei konkaver Bewegungsbahn ein Maximum.

Die Erfindung wird anschliessend beispielsweise anhand von Figuren erläutert. Diese zeigen:
- Fig. 5: anhand einer Prinzipdarstellung, eine erfindungsgemässe Behandlungsanlage bzw. ein erfindungsgemässes Verfahren,
- Fig. 6: schematisch, in Darstellung analog zu Fig. 5, eine erste Realisationsform der erfindungsgemässen Modulation,
- Fig. 7 bis 10: in Darstellungen analog zu den Fig. 1 bis 4, die erfindungsgemässen Weiterbildungen der Anlagen gemäss den Figuren 1 bis 4 bzw. der entsprechenden Herstellungsverfahren,
- Fig. 11: qualitativ (a) eine Schichtdickenverteilung an Substraten, bei deren Fertigung nach Verfahren bzw. mittels Anlagen gemäss den Fig. 1 bis 4; (b) bei für optimale Schichtdicken-Homogenität gewählter, erfindungsgemässer Modulation; (c) bei Überkompensation mit erfindungsgemässer Modulation, und
- Fig. 12: qualitativ das Modulationssignal, erfindungsgemäss an den Anlagen gemäss den Fig. 7 bis 10 angelegt, um an den Substraten Schichtdickenverteilungen gemäss Fig. 11 (b) bzw., gestrichelt dargestellt, (c) zu erzielen.

In Fig. 5 ist schematisch, mit x bezeichnet, die Bewegungsbahn für ein innerhalb einer nicht dargestellten Vakuumbehandlungskammer zu behandelndes Werkstück bzw. Substrat 1 dargestellt. Die momentane Position des Werkstückes 1 entlang der Bewegungsbahn x ist mit xₛ bezeichnet. Innerhalb der Behandlungskammer wird das Werkstück 1 in einem Behandlungsbereich BB in einer Behandlungsatmosphäre U behandelt.

Zur Erzeugung der Behandlungsatmosphäre U sind Organe in der Behandlungskammer vorgesehen bzw. mit ihr wirkverbunden, in Fig. 5 generell mit Block 22 dargestellt. Solche Organe können gebildet sein z.B. durch steuerbare Ventilanordnungen für Gaseinlässe in die Behandlungskammer, insbesondere Reaktivgaseinlässe und/oder Arbeitsgaseinlässe, elektrische Speisespannungen für Plasmaentladungsstrecken, Heiz- oder Kühlorgane, Magnetanordnungen für die Erzeugung von Magnetfeldern in der Kammer. Es ist eine Sensoranordnung 24 vorgesehen, mittels welcher eine oder mehrere charakteristische Grösse(n) der Behandlungsatmosphäre U im Behandlungsbereich BB gemessen wird/werden. Ausgangsseitig ist die Sensoranordnung 24 mit einer Differenzbildungseinheit 26 wirkverbunden, welcher sie ein gemessenes Regelgrössensignal X zuführt. Der Differenzbildungseinheit 26 wird weiter, von einer vorzugsweise einstellbaren SOLL-Wert-Vorgabeeinheit 28a, das SOLL-Wertsignal W zugeführt. Die an der Differenzbildungseinheit 26 resultierende Regeldifferenz wird über einen Regler 30 bzw. Verstärker auf mindestens eines der die Behandlungsatmosphäre U beeinflussenden Organe, als Stellglied, geführt.

Soweit entspricht, generalisiert, die in Fig. 5 beschriebene Anordnung den Ausführungen zu den Fig. 1 bis 4. Erfindungsgemäss wird nun, wie mit dem Positionsdetektor 34 in Fig. 5 schematisch dargestellt, die Momentanposition xₛ eines zu behandelnden Werkstückes 1 erfasst und verfolgt. Das Ausgangssignal der Detektoranordnung 34 löst an einer Modulationseinheit 32 ein mit der Position Xₛ variierendes Modulationssignal M aus, welches mindestens einem der erwähnten, die Behandlungsatmosphäre U mitfestlegenden Organe im Block 22 gemäss Fig. 5 zugeführt wird. Damit wird die Behandlungsatmosphäre U im Behandlungsbereich BB entsprechend dem Modulationssignal M gezielt verändert, so dass das Werkstück 1, während des Durchlaufs durch den Behandlungsbereich BB, entsprechend der gewählten Modulation M mit einem erwünschten Behandlungsprofil entlang seiner zu behandelnden Oberfläche behandelt wird.

Eine erste Realisationsform der erfindungsgemässen Modulation ergibt sich dadurch, dass die Modulation wie in Fig. 6 dargestellt der Führungsgrösse W des Regelkreises aufgebracht wird und damit das Regelkreis-Stellglied auch zum Aufbringen der gezielten Modulation an die Behandlungsumgebung U eingesetzt wird.

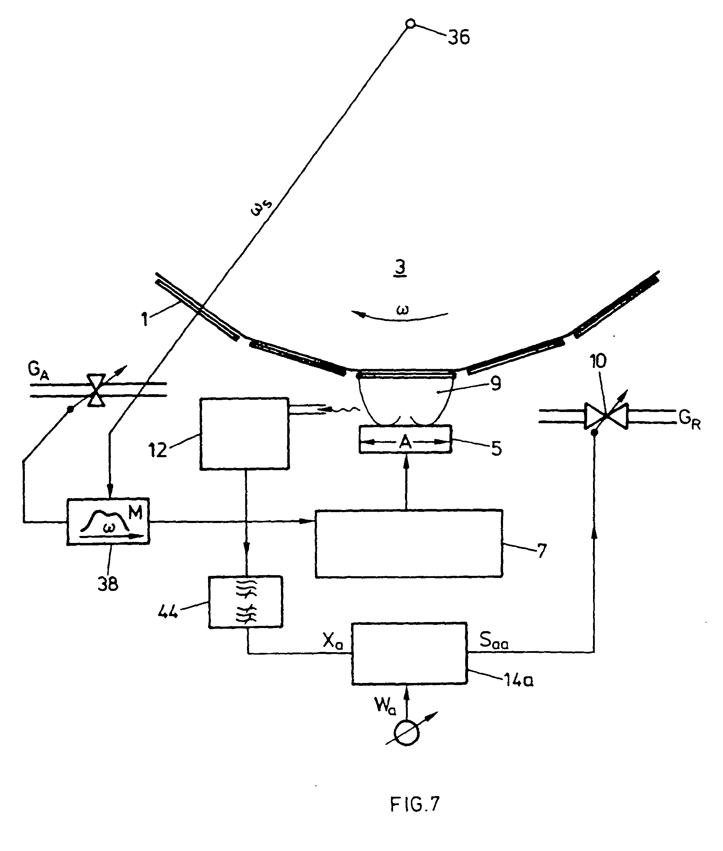

In den Fig. 7 bis 10 sind die bereits beschriebenen, bevorzugten Anlagekonfigurationen gemäss den Fig. 1 bis 4 dargestellt, nun aber erfindungsgemäss weitergebildet. An der Trommel 3 wird als Positionsdetektor 34 gemäss Fig. 5 beispielsweise und bevorzugterweise ein Drehwinkel-Nehmer 36 eingesetzt, welcher - mit dem Drehpositionssignal ωₛ - die Ausgabe des Modulationssignales M(ωₛ) an einer Modulationseinheit 38 mit der Trommelbewegung und damit der Substratbewegung synchronisiert. Bevorzugterweise wird mit dem Modulationssignal M(ωₛ) ein Organ für die Einstellung der Behandlungsatmosphäre U geführt, welches nicht als Stellglied des Regelkreises eingesetzt ist. Dies ist in den Fig. 7 bis 10 durchwegs so dargestellt.

In der in der bevorzugten Ausführungsform realisierten Stabilisierungsregelung des Prozesses, notwendig, um - wie eingangs erläutert - im Übergangsmode ab leitenden Targets mittels Reaktivgas schlecht oder nicht leitende Beschichtungen abzulegen, wird einerseits die Prozessstabilität, anderseits der Durchgriff der vorgesehenen Modulation M(ωₛ) auf die Prozessatmosphäre gewährleistet, indem vorzugsweise das Frequenzverhalten des Regelkreises durch Vorsehen von Filtern 44, vorzugsweise von Tiefpassfiltern oder Bandpassfiltern, weiter bevorzugt im Pfad der gemessenen Regelgrösse, angepasst wird.

In den Fig. 7 bis 10 erfolgt die Modulation zyklisch, entsprechend den jeweils an der Sputterquelle 5 vorbeilaufenden Substraten 1, wobei üblicherweise die Repetitionsfrequenz des periodischen Modulationssignals höher ist als die obere Grenzfrequenz des geschlossenen Regelkreises. So liegen typische Reaktionszeiten der dargestellten Prozessregelung im Bereich einiger hundert Millisekunden bis hin zu einigen Sekunden, während aufgrund der Trommel-Drehgeschwindigkeit ω und der Anzahl vorgesehener Substrate 1 die mit der Trommelbewegung synchronisierte, periodische Modulation eine höhere Repetitionsfrequenz aufweist.

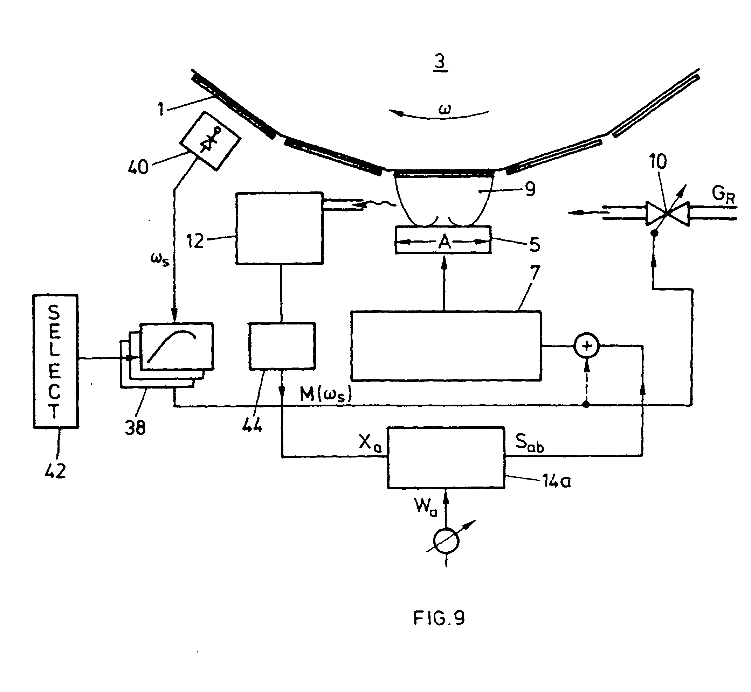

Wie als Beispiel in Fig. 9 dargestellt, kann durchaus anstelle eines Drehwinkel-Nehmers 36, wie in den Fig. 7, 8 und 10 dargestellt, ein Positionsdetektor 40 das Erreichen vordefinierter Substratpositionen an der Trommelperipherie detektieren.

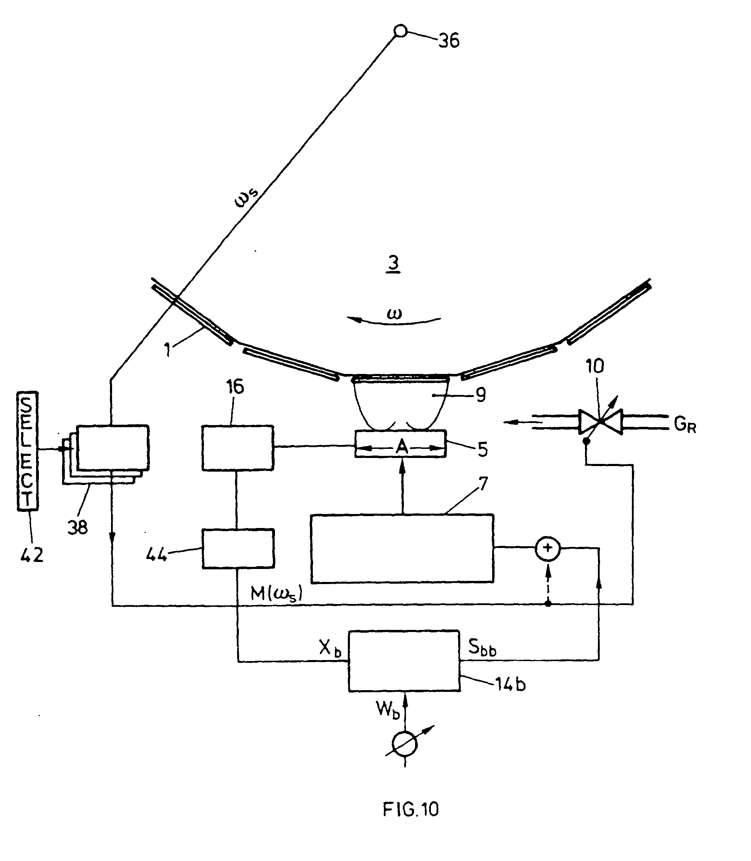

Wie im weiteren in den Fig. 9 und 10 dargestellt, werden bevorzugterweise an der Modulationseinheit 38 eine, vorzugsweise zwei oder mehr Modulationskurvenformen vorabgespeichert und mittels einer Selektionseinheit 42 für den jeweiligen Bearbeitunsprozess selektiv aktiviert. Mit den vorabgelegten, verschiedenen Modulationskurvenformen können unterschiedliche Substratbehandlungen an derselben Anlage berücksichtigt werden.

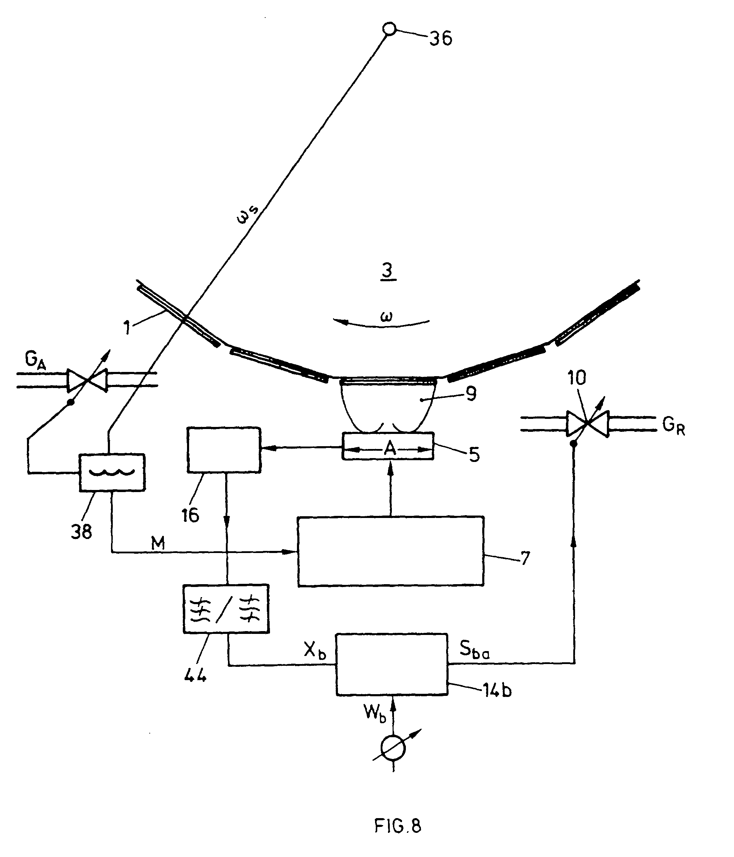

Wie in den Figuren 7 und 8 zusätzlich dargestellt, kann die erfindungsgemäss eingesetzte Modulation durch Modulation des Inertgas- bzw. Arbeitsgasflusses GA erfolgen, für sich allein oder gegebenenfalls in Kombination mit entsprechender Modulation anderer hierzu geeigneter Prozessgrössen, wie Reaktivgasfluss, Sputterleistung.

Im weiteren ist gestrichelt in den Fig. 9 und 10 dargestellt, dass die erfindungsgemäss eingesetzte Modulation auch über das für die Regelung eingesetzte Stellglied - gemäss den erwähnten Figuren die Sputterleistung 7 - realisiert werden kann. Dabei erfolgt diese Modulation langsamer, als durch die Reaktionszeit des geschlossenen Regelkreises gegeben.

Das erfindungsgemässe Vorgehen wird insbesondere bevorzugt für reaktive Beschichtungsverfahren eingesetzt, insbesondere bei der Herstellung optischer Bauelemente. Es erstaunt, dass durch Einsatz der erfindungsgemässen Modulation sich gar für optische Bauelemente eignende, hohe Schichtqualitäten und Schichtprofile erzielt werden.

Insbesondere wird das erfindungsgemässe Vorgehen dann eingesetzt, wenn die eingangs definierte Breite B der Substrate bzw. eines Substrat-Batches grösser ist als die zugeordnete Sputterquellenausdehnung A, vorzugsweise wesentlich grösser, insbesondere mindestens fünfmal grösser.

In Fig. 11 zeigt qualitativ die Kurve (a) die auf einem planen Substrat 1 gemäss den Fig. 1 bis 4 durch Sputtern ab der Quelle 5 aufgebrachte Schichtdickenverteilung, und zwar unabhängig davon, ob es sich um das Ablegen von Targetmaterial-Schichten im metallischen Mode oder um das Ablegen von wie im Intramode bzw. Übergangsmode zu elektrisch nicht leitenden Schichten reagierten Schichtmaterialien handelt. Durch Aufbringen einer Modulation M(ωₛ) gemäss den Fig. 7 bis 10 und wie in Fig. 12 dargestellt, kann der Verlauf (a) von Fig. 11 exakt kompensiert werden, es ergibt sich eine Schichtdickenverteilung an den Substraten, wie mit (b) in Fig. 11 dargestellt. Bei Überkompensation mit der eingesetzten Modulation, wie beispielsweise in Fig. 12 gestrichelt dargestellt, ergibt sich eine Schichtdikkenverteilung, wie sie in Fig. 11 bei (c) wiedergegeben ist. An den Stellen P₁, P₂ ... von Fig. 12 durchläuft die modulierte Behandlungsatmosphäre ein Intensitäts-Minimum, dort liegen die jeweiligen Substrate 1 zentriert der Sputterquelle gegenüber.

Es versteht sich von selber, dass bei Übergang von konvexer Bewegungsbahn auf konkave, bezüglich der Sputterquelle, die bevorzugt eingesetzten Minimum/Maximum-Zuordnungen der Modulationen invertiert werden.

Demnach wurde erkannt, dass bei Anlagen der in den Fig. 1 bis 4 dargestellten Art auch bei Sputterbeschichten im Metallmode, d.h. ohne Reaktivgas, durch Minimalisierung der Sputterleistung dann, wenn die Substrate zentriert über der Sputterquelle liegen, der Sehneneffekt kompensiert werden kann.

Es ergibt sich dadurch eine optimale Gleichförmigkeit der Schichtdicke über der Substratbreite B, was z.B. bei Substratbreiten von mindestens 12 cm von wesentlicher Bedeutung ist. Die Anpassung der Modulationskurvenformen erlaubt dabei, gezielt erwünschte Behandlungs-, im bevorzugten Fall Beschichtungsverteilungen, zu erzielen. Auch mechanische Ungenauigkeiten der Anlagenkonfiguration, wie beispielsweise von Substratträgern, können durch entsprechend ausgelegte Modulationsformen kompensiert werden. Erwünschtenfalls ist es auch möglich, bei gleichzeitig auf der Trommel 3 vorgesehenen Werkstücken, die aber mit unterschiedlichen Schichtdicken-Verteilungen zu beschichten sind, dies durch Aufschalten jeweils unterschiedlicher Modulationskurvenformen zu realisieren, z.B. durch Zähler (nicht dargestellt) wird dann detektiert, welche der Substrate momentan in den Behandlungsbereich BB der Sputterquelle einfahren, und es wird die entsprechend zugehörige Modulationskurvenform mit der Selektionseinheit 42 aktiviert.

Die Möglichkeit, dass erfindungsgemäss die Schichtdickenverteilung an den vorbeibewegten Substraten gezielt eingestellt wird, ermöglicht es, die Präzisionsanforderungen an die Behandlungsanlage - insbesondere, was deren Werkstückträger und exakte Positionierung der Sputterquelle anbelangt - zu verringern. Dadurch primär entstehende, unerwünschte Schichtdickenverteilungen werden mit der erfindungsgemäss eingesetzten Modulation kompensiert.

Im weiteren können auch gezielt bestimmte erwünschte Schichtdicken-Verteilungen bzw. -Profile, z.B. für Gradientenfilter, realisiert werden. Ein wesentlicher Aspekt der vorliegenden Erfindung ist es auch, nichtebene Substrate, beispielsweise Linsenkörper, mit einer gleichförmigen Schichtdickenverteilung zu beschichten.

## Patentansprüche

1. Vakuumbehandlungsanlage mit einer Vakuumbehandlungskammer, mit Organen (22) zum Erstellen einer Behandlungsatmosphäre (U) in einem Behandlungsbereich (BB), mit einer Sensoranordnung (24) zur Erfassung der im Behandlungsbereich momentan vorherrschenden Behandlungsatmosphäre (U), wobei die Sensoranordnung IST-Wertaufnehmer, mindestens eines der Organe Stellglied eines Regelkreises für die Behandlungsatmosphäre im Behandlungsbereich ist, weiter mit einer einstellbaren SOLL-Wert-Vorgabeeinheit für die Behandlungsatmosphäre im Behandlungsbereich, und mit einem in der Kammer durch den Behandlungsbereich bewegten Werkstückträger, **dadurch gekennzeichnet, dass** mindestens eines der Organe (22) in Funktion der Werkstückträgerposition (XS) die Behandlungsatmosphäre (U) im Behandlungsbereich (BB) nach einem gegebenen Profil (M) moduliert, indem am Regelkreis die einstellbare SOLL-Wertvorgabeeinheit (28a) die Modulation (M) über Modulation des SOLL-Wertes (W(M)) vornimmt oder die Modulation (M) in einem Frequenzbereich erfolgt, welcher über der oberen Grenzfrequenz des geschlossenen Regelkreises der Regelung liegt.

2. Anlage nach Anspruch 1, **dadurch gekennzeichnet, dass** in der Vakuumkammer mindestens eine Sputterquelle (5) mit elektrisch leitendem Target vorgesehen ist, weiter die Kammer an eine Reaktivgas-Tankanordnung mit einem Reaktivgas (GR) angeschlossen ist, welches mit dem durch die Sputterquelle freigesetzten Material zu einem bezüglich des Targets elektrisch schlechter leitenden Material als Beschichtungsmaterial reagiert und dass die Modulation an der elektrischen Quelle (7) für die Sputterquelle (5) vorgenommen wird, dabei vorzugsweise an einem DC-Speisegenerator für die Sputterquelle und/oder an einer zwischen einem DC-Speisegenerator und der Sputterquelle geschalteten Choppereinheit.

3. Anlage nach Anspruch 1 oder 2, **dadurch gekennzeichnet, dass** der bewegte Werktstückträger durch eine in der Kammer getrieben rotierende Trägertrommel (3) oder ein Trägerkarussell gebildet ist mit daran verteilten Werkstückaufnahmen, und dass die Modulation mit der Trommel-/Karussel-Drehbewegung ( ) synchronisiert ist und mit einer Repetitionsfrequenz vorgenommen wird, die der Werkstückträger-Durchlauffrequenz an einem kammerfesten Ort im Bereich der Trommel bzw. des Karussells (3) entspricht.

4. Anlage nach einem der Ansprüche 1 bis 3, **dadurch gekennzeichnet, dass** eine Modulationsformen-Speichereinheit (38) vorgesehen ist mit mindestens einem, vorzugsweise mehr als einem vorab gespeicherten Modulationsverlauf und eine Selektionseinheit (42) vorgesehen ist zum selektiven Aufschalten des erwünschten Modulationsverlaufes.

5. Verfahren zur Herstellung von Werkstücken, bei dem die Werkstücke einer Vakuumbehandlung zugeführt werden, worin sie durch eine Regelung geführte Behandlungsatmosphäre (U) in einem Behandlungsbereich (BB) durchgebewegt werden, **dadurch gekennzeichnet, dass** die Behandlungsatmosphäre (U) im Behandlungsbereich in Funktion der Werkstückposition (XS) mit einem vorgegebenen Profil (M) moduliert wird, wobei dieses Modulieren durch Modulation des SOLL-Wertes (W(M)) an der Regelung oder in einem Frequenzbereich erfolgt, welcher über der oberen Grenzfrequenz des geschlossenen Kreises der Regelung liegt.

6. Verfahren nach Anspruch 5, **dadurch gekennzeichnet, dass** die Werkstücke in der Vakuumkammer an einer Sputterquelle (5) mit elektrisch leitendem Target vorbeibewegt werden, in die Kammer ein Reaktivgas (GR) eingelassen wird, womit das von der Sputterquelle (5) freigesetzte Material eine bezüglich des Targets elektrisch schlechter leitende Verbindung als Beschichtungsmaterial für die Werkstücke eingeht, und dass die Modulation an der elektrischen Sputterquellenspeisung (7) vorgenommen wird.

7. Verfahren nach Anspruch 6, **dadurch gekennzeichnet, dass** die Sputterquelle (5) von einem DC-Generator gespiesen wird und vorzugsweise zwischen Generator und Sputterquelle ein gesteuert hoch- und niederohmig geschalteter Strompfad die Sputterquellen-Speisungsanschlüsse überbrückt.

8. Verfahren nach einem der Ansprüche 5 bis 7, **dadurch gekennzeichnet, dass** Werkstücke periodisch an einer Behandlungsquelle (5) in der Kammer vorbeibewegt werden und die Modulation synchronisiert mit der periodischen Werkstück-Durchbewegung vorgenommen wird.

9. Verfahren nach Anspruch 8, **dadurch gekennzeichnet, dass** die Werkstücke auf einer bezüglich der Behandlungsquelle konvexen oder konkaven Kreisbahn (3) an der Quelle (5) vorbeibewegt werden.

10. Verfahren nach einem der Ansprüche 5 bis 9, **dadurch gekennzeichnet, dass** verschiedene Modulationskurven-Verläufe vorabgespeichert werden und selektiv für die Modulation der Behandlungsatmosphäre aufgeschaltet werden.

11. Verfahren nach Anspruch 5, **dadurch gekennzeichnet, dass** die Werkstücke an einer Sputterquelle (5) vorbeibewegt werden, auf einer bezüglich Sputterquelle konvexen oder konkaven Kreisbahn (3), und dass man die Sputterquellenleistung in Funktion der Substratposition so moduliert, dass bei zentrisch gegenüber der Sputterquelle (5) liegenden Werkstücken (1) die Sputterleistung bei konvexer Kreisbahn ein Minimum durchläuft, bei konkaver ein Maximum.

12. Verfahren nach Anspruch 5, **dadurch gekennzeichnet, dass** die Werkstücke einer reaktiven Vakuumbehandlung zugeführt werden, an einer Sputterquelle (5) vorbeigewegt werden, auf einer bezüglich Sputterquelle konvexen oder konkaven Kreisbahn (3), und dass man den Reaktivgasfluss in Funktion der Substratposition moduliert, vorzugsweise so, dass bei zentrisch gegenüber der Sputterquelle liegendem Werkstück der Fluss des Reaktivgases bei konvexer Kreisbahn ein Maximum durchläuft, bei konkaver hingegen ein Minimum.

13. Verfahren nach Anspruch 5, **dadurch gekennzeichnet, dass** die Werkstücke an einer Sputterquelle (5) vorbeibewegt werden, auf einer bezüglich Sputterquelle konvexen oder konkaven Kreisbahn (3), und dass man den Arbeitsgasfluss in Funktion der Substratposition moduliert, vorzugsweise, dass bei zentrisch gegenüber der Sputterquelle liegendem Werkstück der Fluss bei konvexer Bahn ein Minimum durchläuft, bei konkaver ein Maximum.

14. Verwendung der Anlage nach einem der Ansprüche 1 bis 4 bzw. des Verfahrens nach einem der Ansprüche 5 bis 13 für das Behandeln planer Substrate mit einer Ausdehnung grösser als diejenige der Sputterquelle, insbesondere zu deren Beschichtung, insbesondere zu deren reaktivem Sputterbeschichten.

15. Verwendung der Anlage nach einem der Ansprüche 1 bis 4 bzw. des Verfahrens nach einem der Ansprüche 5 bis 13 für die Beschichtung optischer Bauteile, vorzugsweise für deren reaktive Beschichtung.

## Claims

1. Vacuum treatment plant with a vacuum treatment chamber with means (22) to create a treatment atmosphere (U) in a treatment area (BB), with a sensor arrangement (24) to detect the treatment atmosphere (U) momentarily prevailing in the treatment area, where the sensor arrangement is an actual value sensor, at least one of the means is an actuator of a closed control circuit for the treatment atmosphere in the treatment area, furthermore with an adjustable nominal value presetting unit for the treatment atmosphere in the treatment area, and with a workpiece carrier moved through the treatment area in the chamber, **characterised in that** at least one of the means (22) modulates as a function of the workpiece carrier position (XS) the treatment atmosphere (U) in the treatment area (BB) according to a given profile (M), **in that** on the closed control circuit the adjustable nominal value presetting unit (28a) performs the modulation (M) by modulating the nominal value (W(M)) or modulation (M) is performed in a frequency range which lies above the upper limit frequency of the closed control circuit of the negative feedback control system.

2. Plant according to claim 1, **characterised in that** in the vacuum chamber is provided at least one sputter source (5) with electrically conductive target, furthermore the chamber is connected to a reactive gas tank arrangement with a reactive gas (GR) which reacts with the material released by the sputter source into a material which is less conductive electrically in relation to the target as a coating material, and that the modulation is performed at the electrical source (7) for the sputter source (5), preferably at a DC feed generator for the sputter source and/or at a chopper unit connected between a DC feed generator and the sputter source.

3. Plant according to claim 1 or 2, **characterised in that** the moved workpiece carrier is formed by a carrier drum (3) driven rotating in the chamber or a carrier carousel with workpiece holders distributed thereon, and that the modulation is synchronised with the drum/carousel rotary movement and performed with a repetition frequency which corresponds to the frequency with which the workpiece carrier passes a chamber-stationary location in the area of the drum or carousel (3).

4. Plant according to any of claims 1 to 3, **characterised in that** a modulation form memory unit (38) is provided with at least one, preferably more than one previously stored modulation course, and a selection unit (42) is provided for selective connection of the desired modulation course.

5. Process for manufacturing workpieces in which the workpieces are supplied for vacuum treatment, in which they are moved through a treatment atmosphere (U) controlled by a control system into a treatment area (BB), **characterised in that** the treatment atmosphere (U) is modulated with a given profile (M) in the treatment area as a function of the workpiece position (XS), where this modulation takes place by modulation of the nominal value (W(M)) at the control system or in a frequency range which lies above the upper frequency limit of the closed control circuit.

6. Process according to claim 5, **characterised in that** in the vacuum chamber the workpieces are moved past a sputter source (5) with electrically conductive target, a reactive gas (GR) is introduced into the chamber, whereby the material released by this sputter source (5) forms part of a compound which is less conductive electrically than the target as the coating material for the workpieces, and that the modulation is carried out on the electrical sputter source feed (7).

7. Process according to claim 6, **characterised in that** the sputter source (5) is fed by a DC generator and preferably between the generator and sputter source a controlled current path switched high and low ohm bridges the sputter source feed connections.

8. Process according to any of claims 5 to 7, **characterised in that** workpieces are periodically moved past a treatment source (5) in the chamber and the modulation is carried out in synchrony with a periodic workpiece movement.

9. Process according to claim 8, **characterised in that** the workpieces are moved past the source (5) on a circular track (3) which is convex or concave in relation to the treatment source.

10. Process according to any of claims 5 to 9, **characterised in that** different modulation curves are previously stored and connected selectively for modulation of the treatment atmosphere.

11. Process according to claim 5, **characterised in that** the workpieces are moved past a sputter source (5) on a circular track (3) which is convex or concave in relation to the sputter source, and that the sputter source power is modulated as a function of the substrate position so that for workpieces (1) lying centred opposite the sputter source (5), the sputter power passes through a minimum for a convex track and a maximum for a concave track.

12. Process according to claim 5, **characterised in that** the workpieces are supplied to a reactive vacuum processing, moved past a sputter source (5) on a circular track (3) which is convex or concave in relation to the sputter source, and that the reactive gas flow is modulated as a function of the substrate position preferably so that with the workpiece lying centrally opposite the sputter source the flow of the reactive gas passes through a maximum for a convex track, but in contrast a minimum for a concave track.

13. Process according to claim 5, **characterised in that** workpieces are moved past a sputter source (5) on a circular track (3) which is convex or concave in relation to the sputter source, and that the working gas flow is modulated as a function of the substrate position, preferably so that with the workpiece lying centrally opposite the sputter source the flow passes through a minimum for a convex path and a maximum for a concave path.

14. Use of the plant according to any of claims 1 to 4 or the process according to any of claims 5 to 13 to treat planar substrates with an extension greater than that of the sputter source, in particular for their coating, in particular for their reactive sputter coating.

15. Use of the plant according to any of claims 1 to 4, or the process according to any of claims 5 to 13, for coating optical components, preferably for their reactive coating.

## Revendications

1. Installation de traitement sous vide comprenant une chambre de traitement sous vide, des organes (22) pour établir une atmosphère de traitement (U) dans une zone de traitement (BB), un dispositif capteur (24) pour détecter l'atmosphère de traitement (U) prédominante momentanément dans la zone de traitement, le dispositif capteur étant constitué par un capteur de valeurs réelles et l'un au moins des organes par un actionneur d'un circuit de régulation pour l'atmosphère de traitement dans la zone de traitement, une unité réglable de prédéfinition de valeurs de consigne pour l'atmosphère de traitement dans la zone de traitement, et enfin un porte-pièce déplacé à travers la zone de traitement dans la chambre,
**caractérisée en ce que** l'un au moins des organes (22) module suivant un profil donné (M) l'atmosphère de traitement (U) dans la zone de traitement (BB) en fonction de la position (XS) du porte-pièce, grâce au fait qu'au niveau du circuit de régulation, l'unité réglable de prédéfinition de valeurs de consigne (28a) procède à la modulation (M) par l'intermédiaire d'une modulation de la valeur de consigne (W(M)) ou que la modulation (M) a lieu dans une plage de fréquence qui est située au-dessus de la fréquence limite supérieure du circuit de régulation fermé de la régulation.

2. Installation selon la revendication 1, **caractérisée en ce qu'**il est prévu dans la chambre à vide au moins une source de pulvérisation cathodique (5) avec une cible conductrice d'électricité, et la chambre est reliée à un dispositif formant réservoir de gaz réactif contenant un gaz réactif (GR) qui réagit avec la matière libérée par la source de pulvérisation cathodique pour donner une matière plus mauvaise conductrice d'électricité comparée à celle de la cible, comme matière de revêtement, et **en ce que** la modulation est réalisée au niveau de la source électrique (7) pour la source de pulvérisation cathodique (5), de préférence au niveau d'un générateur d'alimentation en courant continu pour la source de pulvérisation cathodique et/ou au niveau d'une unité chopper montée entre un générateur d'alimentation en courant continu et la source de pulvérisation cathodique.

3. Installation selon la revendication 1 ou 2, **caractérisée en ce que** le porte-pièce déplacé est formé par un tambour porte-pièce (3) entraîné en rotation dans la chambre ou par un carrousel porte-pièce sur lequel sont répartis des logements de pièce, et **en ce que** la modulation est synchronisée avec la rotation (ω) du tambour/du carrousel et est réalisée avec une fréquence de répétition qui correspond à la fréquence de passage du porte-pièce à un endroit fixe de la chambre, dans la zone du tambour ou du carrousel (3).

4. Installation selon l'une des revendications 1 à 3, **caractérisée en ce qu'**il est prévu une unité de mise en mémoire de formes de modulation (38) qui contient au moins une et de préférence plus d'une courbe de modulation mise en mémoire préalablement, et une unité de sélection (42) pour déclencher sélectivement la courbe de modulation souhaitée.

5. Procédé pour fabriquer des pièces, selon lequel les pièces sont amenées vers un traitement sous vide lors duquel elles sont déplacées à travers une atmosphère de traitement (U) commandée par une régulation, dans une zone de traitement (BB),
**caractérisé en ce que** l'atmosphère de traitement (U) dans la zone de traitement est modulée suivant un profil (M) prédéfini, en fonction de la position (XS) de la pièce, cette modulation se faisant grâce à une modulation de la valeur de consigne (W(M)) au niveau de la régulation ou dans une plage de fréquence qui est située au-dessus de la fréquence limite supérieure du circuit fermé de la régulation.

6. Procédé selon la revendication 5, **caractérisé en ce que** les pièces, dans la chambre à vide, passent devant une source de pulvérisation cathodique (5) avec une cible conductrice d'électricité, et un gaz réactif (GR) est introduit dans la chambre, moyennant quoi la matière libérée par la source (5) est soumise à une liaison plus mauvaise conductrice d'électricité comparé à celle de la cible, comme matière de revêtement pour les pièces, et **en ce que** la modulation est réalisée au niveau de l'alimentation électrique (7) de la source de pulvérisation cathodique.

7. Procédé selon la revendication 6, **caractérisé en ce que** la source de pulvérisation cathodique (5) est alimentée par un générateur de courant continu, et de préférence entre le générateur et la source de pulvérisation cathodique, un circuit de courant monté de manière commandée avec une valeur ohmique élevée et faible court-circuite les raccordements d'alimentation de la source de pulvérisation cathodique.

8. Procédé selon l'une des revendications 5 à 7, **caractérisé en ce que** les pièces passent périodiquement devant une source de traitement (5), dans la chambre, et la modulation est réalisée de manière synchronisée avec le passage périodique des pièces.

9. Procédé selon la revendication 8, **caractérisé en ce que** les pièces passent devant la source (5) en suivant une trajectoire circulaire (3) convexe ou concave par rapport à celle-ci.

10. Procédé selon l'une des revendications 5 à 9, **caractérisé en ce que** différentes courbes de modulation sont mises en mémoire préalablement et sont déclenchées sélectivement pour la modulation de l'atmosphère de traitement.

11. Procédé selon la revendication 5, **caractérisé en ce que** les pièces passent devant une source de pulvérisation cathodique (5) suivant une trajectoire circulaire (3) convexe ou concave par rapport à celle-ci, et **en ce qu'**on module la puissance de ladite source (5) en fonction de la position du substrat de telle sorte que si les pièces (1) sont centrées par rapport à la source (5), la puissance de pulvérisation cathodique traverse un minimum dans le cas d'une trajectoire circulaire convexe, et un maximum dans le cas d'une trajectoire circulaire concave.

12. Procédé selon la revendication 5, **caractérisé en ce que** les pièces sont amenées vers un traitement sous vide réactif et passent devant une source de pulvérisation cathodique (5) suivant une trajectoire circulaire (3) convexe ou concave par rapport à celle-ci, et **en ce qu'**on module le flux de gaz réactif en fonction de la position du substrat, de préférence de telle sorte que si la pièce est centrée par rapport à ladite source, le flux du gaz réactif traverse un maximum dans le cas d'une trajectoire circulaire convexe, et au contraire un minimum dans le cas d'une trajectoire circulaire concave.

13. Procédé selon la revendication 5, **caractérisé en ce que** les pièces passent devant une source de pulvérisation cathodique (5) suivant une trajectoire circulaire (3) convexe ou concave par rapport à celle-ci, et **en ce qu'**on module le flux de gaz de travail en fonction de la position du substrat, de préférence de telle sorte que si la pièce est centrée par rapport à ladite source, le flux traverse un minimum dans le cas d'une trajectoire convexe, et un maximum dans le cas d'une trajectoire concave.

14. Utilisation de l'installation selon l'une des revendications 1 à 4 ou du procédé selon l'une des revendications 5 à 13 pour le traitement de substrats plats ayant une extension plus grande que celle de la source de pulvérisation cathodique, en particulier pour l'application d'un revêtement sur ces substrats, en particulier pour l'application réactive d'un revêtement par pulvérisation cathodique.

15. Utilisation de l'installation selon l'une des revendications 1 à 4 ou du procédé selon l'une des revendications 5 à 13 pour l'application, de préférence réactive, d'un revêtement sur des composants optiques.
